Europäisches Patentamt

European Patent Office

Office européen des brevets

(19)

(11) Publication number: **0 185 096 B1**

# EUROPEAN PATENT SPECIFICATION

(12)

(45) Date of publication of patent specification: **13.11.91**  (51) Int. Cl.5: **H04N 3/27**

(21) Application number: **85902650.2**

(22) Date of filing: **29.05.85**

(86) International application number:
**PCT/JP85/00293**

(87) International publication number:
**WO 85/05751 (19.12.85 85/27)**

(54) **APPARATUS FOR CONTROLLING AMPLITUDE OF VERTICALLY DEFLECTING SIGNALS.**

(30) Priority: **29.05.84 JP 109257/84**

(43) Date of publication of application:
**25.06.86 Bulletin 86/26**

(45) Publication of the grant of the patent:
**13.11.91 Bulletin 91/46**

(84) Designated Contracting States:
**DE FR GB NL**

(56) References cited:

| | |
|---|---|
| **JP-A- 5 432 016** | **JP-U- 5 871 266** |
| **JP-U-55 176 671** | **US-A- 3 944 737** |
| **US-A- 4 104 567** | **US-A- 4 164 688** |

(73) Proprietor: **SONY CORPORATION**
**7-35 Kitashinagawa 6-Chome Shinagawa-ku Tokyo 141(JP)**

(72) Inventor: **KIKUCHI, Masafumi Sony Corporation**
**7-35, Kitashinagawa 6-chome**
**Shinagawa-ku Tokyo 141(JP)**

(74) Representative: **Thomas, Christopher Hugo et al**
**D Young & Co 10 Staple Inn**
**London WC1V 7RD(GB)**

## Description

This invention relates to apparatus for controlling the amplitude of a vertical deflection signal.

When a television receiver is used as an output display of a microcomputer apparatus, the vertical frequency of an output video signal from the microcomputer apparatus is determined by the number of characters in one line and is not limited to a standard television frequency of say 60Hz, but lies within a range of, for example, 50 to 60Hz. Thus when such a video signal is supplied to a television receiver, there occur problems such as inferior vertical linearity, worse horizontal pin distortion, vertical pull-out, and over or under amplitude of the vertical deflection.

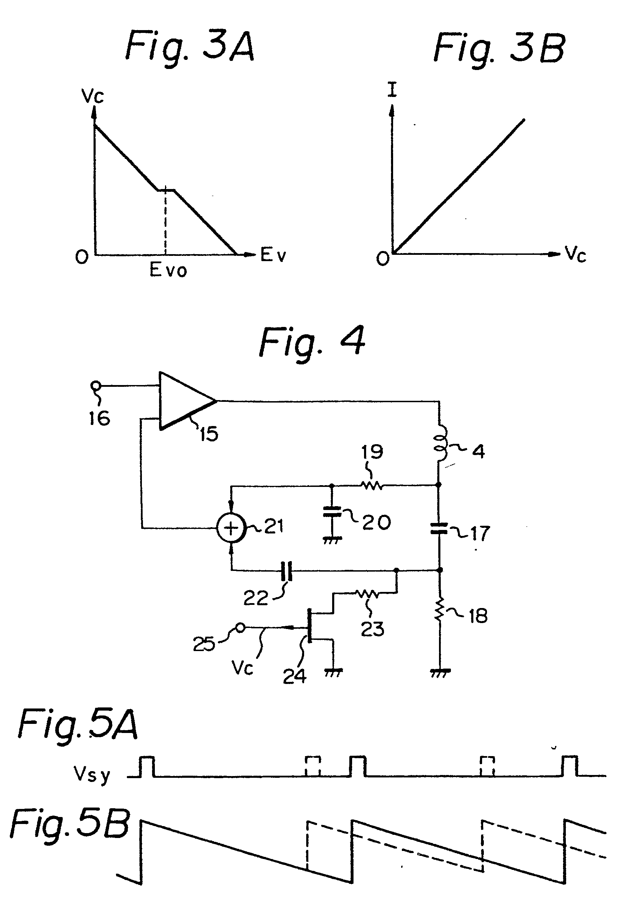

For example, assuming that the frequency of a vertical sync signal $V_{sy}$ shown in Figure 5A increases as shown by the broken lines compared with that represented by the solid lines, then the amplitude of the vertical deflection signal decreases as shown by the broken lines in Figure 5B.

It has been proposed to correct the change in vertical amplitude due to the difference in vertical frequency between the NTSC and CCIR systems by manual switching in dependence on the television signal to be received.

To correct the vertical amplitude automatically, it is necessary to detect the variation in vertical amplitude corresponding to the vertical frequency of the input signal. To do this it has been proposed that a monostable multivibrator be triggered by the vertical sync signal and its output signal integrated, the vertical frequency being determined from the level of the integrated output. However, since the vertical frequency is fairly low, the value of the capacitor required for the integration is large, and there is the problem that the response speed when the vertical frequency changes is low.

According to the present invention there is provided apparatus for controlling the amplitude of a vertical deflection signal, the apparatus comprising:
a vertical oscillating circuit for generating a sawtooth signal having a vertical blanking period;
a detecting circuit for detecting whether the amplitude of said sawtooth signal is in a predetermined level range;
a counter for counting a vertical synchronizing signal, in response to an output of said detecting circuit, when the amplitude of said sawtooth signal is out of said range; and
a digital-to-analogue converter for converting an output of said counter into an analogue detection signal, the output of said digital-to-analogue converter being supplied to said vertical oscillating circuit;
the amplitude of a vertical deflection signal formed by said sawtooth signal being controlled by an output of said digital-to-analogue converter.

The invention will now be described by way of example with reference to the accompanying drawings, throughout which like parts are referred to by like references, and in which:
Figure 1 is a block diagram of an embodiment of the present invention;
Figure 2 is a waveform diagram for explaining the operation;
Figure 3 is a graphical diagram for explaining the operation;
Figure 4 is a circuit diagram of another embodiment of the invention; and
Figure 5 is a waveform diagram for explaining variation in vertical amplitude.

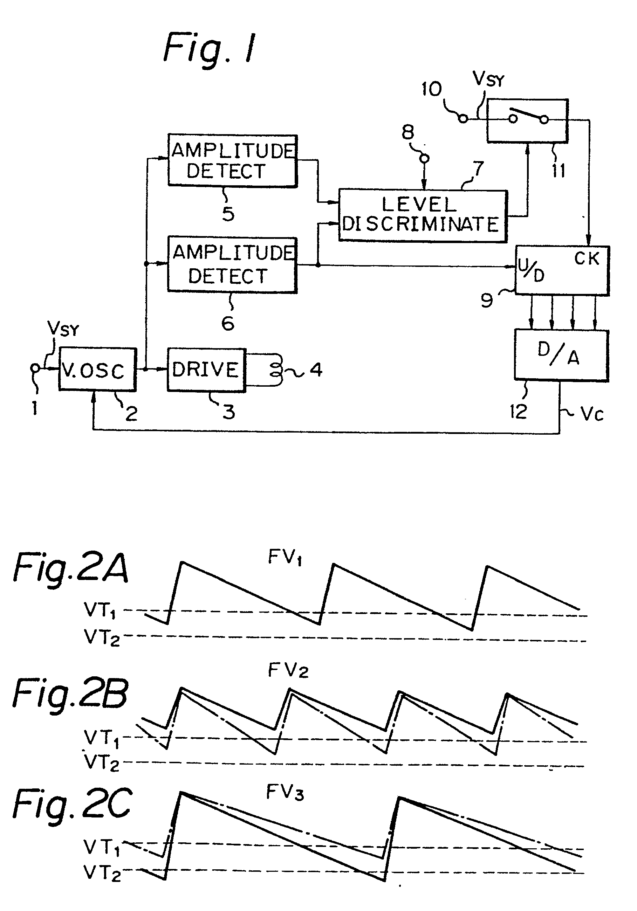

Figure 1 shows an embodiment comprising an input terminal 1 receiving a vertical sync signal $V_{sy}$, a vertical oscillating circuit 2, a vertical drive circuit 3, and a vertical deflection coil 4.

The vertical sawtooth voltage appearing as an output of the vertical oscillating circuit 2 is supplied to amplitude detecting circuits 5 and 6. The amplitude detecting circuit 5 compares an amplitude $E_v$ of the sawtooth voltage with a reference voltage $VT_1$. The amplitude detecting circuit 6 compares the amplitude $E_v$ of the sawtooth voltage with a reference voltage $VT_2$. The amplitude detecting circuit 5 generates a detection signal which becomes H (high level) when $VT_1 < E_v$ and becomes L (low level) in other cases. The amplitude detecting circuit 6 generates a detection signal which becomes H when $VT_2 > E_v$ and becomes L in other cases.

The detection signals of the amplitude detecting circuits 5 and 6 are supplied to a level discriminating circuit 7. A vertical blanking signal is supplied from a terminal 8 to the level discriminating circuit 7 which discriminates the level only for the vertical blanking interval. For the vertical blanking interval, the level discriminating circuit 7 generates a discrimination output which becomes H when one of the detection signals of the amplitude detecting circuits 5 and 6 is H, and becomes L when both of these detection signals are L.

A detection output of the amplitude detecting circuit 6 is supplied to an up/down counter 9 as a signal to control the count direction. When the detection output is L, the counter 9 counts up. When the detection output is H, the counter 9 counts down. The vertical sync signal $V_{sy}$ from a terminal 10 is supplied as a clock input to the counter 9 through a gate circuit 11. Thus, the content of the counter 9 is increased or decreased one by one for every vertical period by the vertical sync signal $V_{sy}$.

The gate circuit 11 is turned on when the discrimination output of the level discriminating circuit 7 is H, and is turned off when the discrimination output of the level discriminating circuit 7 is L. The discrimination output of the level discriminating circuit 7 may be supplied to a counter enable terminal in place of the gate circuit 11.

The output signal, for example, a four-bit output of the counter 9 is supplied to a D/A converter 12 and converted into an analogue control voltage $V_c$. The control voltage $V_c$ is supplied as a correction signal to the vertical oscillating circuit 2. In this embodiment, the magnitude of a discharging constant current of an integrator to generate the sawtooth voltage of the vertical oscillating circuit 2 is controlled by the control voltage $V_c$.

The operation will now be described with reference to Figures 2 and 3.

Figure 2A shows a state in which the vertical frequency is $FV_1$ and the amplitude of the vertical deflection signal is correct. The level relation $VT_1 > E_v > VT_2$ is satisfied within the vertical blanking interval. At this time, the detection outputs of the amplitude detecting circuits 5 and 6 are L and the gate circuit 11 is not turned on, so that the content of the counter 9 does not change.

When the vertical frequency increases from $FV_1$ and becomes $FV_2$, the vertical amplitude $E_v$ decreases as shown in Figure 2B. At this time, the vertical amplitude $E_v$ increases for the vertical blanking interval with respect to the reference voltages $VT_1$ and $VT_2$. Thus, the detection output of the amplitude detecting circuit 5 becomes H and the output of the amplitude detecting circuit 6 becomes L, and the discriminating output of the level discriminating circuit 7 becomes H. The gate circuit 11 is turned on due to this discrimination output and the vertical sync signal $V_{sy}$ is counted by the counter 9. In addition, since the detection output of the amplitude detecting circuit 6 is L, the counter 9 counts up and the content is increased by '1', and the control voltage $V_c$ from the D/A converter 12 increases.

A check is likewise made to see if the vertical amplitude $E_v$ is correct or not for the next vertical blanking interval. If the amplitude is still low, the counter 9 counts the vertical sync signal $V_{sy}$ and the control voltage $V_c$ increases. By repeating this operation, the proper vertical amplitude $E_v$ is derived.

When the vertical frequency decreases from $FV_1$ and becomes $FV_3$, the vertical amplitude $E_v$ increases as shown in Figure 2C. At this time, the vertical amplitude $E_v$ decreases for the vertical blanking interval with respect to the reference voltages $VT_1$ and $VT_2$. Therefore, the detection output of the amplitude detecting circuit 5 is L and the output of the amplitude detecting circuit 6 becomes H and the discrimination output of the level discriminating circuit 7 becomes H. The gate circuit 11 is turned on due to this discrimination output and the vertical sync signal $V_{sy}$ is counted by the counter 9. On one hand, since the detection output of the amplitude detecting circuit 6 is H, the counter 9 counts down, so that the content is reduced by '1', and the control voltage $V_c$ from the D/A converter 12 decreases.

A check is similarly made to see if the vertical amplitude $E_v$ is correct or not for the next vertical blanking interval. If the amplitude is still large, the counter 9 counts the vertical sync signal $V_{sy}$ and the control voltage $V_c$ decreases. By repeating this operation, the proper vertical amplitude $E_v$ is obtained.

Figure 3A shows the relation between the vertical amplitude $E_v$ and the control voltage $V_c$. The control voltage $V_c$ does not change when the vertical amplitude $E_v$ lies within a predetermined range around the proper amplitude value $E_{v0}$. When the vertical amplitude $E_v$ deviates from this predetermined range, the control voltage $V_c$ changes in correspondence with the vertical amplitude $E_v$.

On the other hand, there is the relation as shown in Figure 3B between the control voltage $V_c$ and the discharging constant current I. The discharging constant current I changes in proportion to the control voltage $V_c$. Therefore, as shown in Figure 2B, when the vertical amplitude $E_v$ becomes too small, the discharging constant current I is increased and as indicated by an alternate long and short dash line, the gradient of the sawtooth voltage is increased and the vertical amplitude $E_v$ is corrected so as to be enlarged. On the contrary, when the vertical amplitude $E_v$ becomes too large as shown in Figure 2C, the discharging constant current I is reduced and as indicated by an alternate long and short dash line, the gradient of the sawtooth voltage is decreased and the vertical amplitude $E_v$ is corrected so as to be reduced.

Due to the above operation, the amplitude is automatically controlled so that the vertical amplitude $E_v$ lies within a predetermined range around the proper amplitude value $E_{v0}$. This predetermined range is determined by the reference voltages $VT_1$ and $VT_2$ and its magnitude is selected to a value such that the amplitude difference of the vertical deflection does not cause a visual problem.

Figure 4 shows another example of the circuit to correct the vertical amplitude $E_v$. A series circuit of the vertical deflection coil 4, a capacitor 17, and a detecting resistor 18 is connected between an output of a vertical drive amplifier 15 and earth. A vertical parabolic voltage which is generated at a connecting point of the vertical deflection coil 4 and the capacitor 17 is supplied to an adding circuit 21 through an integrating circuit comprising a resistor 19 and a capacitor 20. A sawtooth voltage which is generated across the detecting resistor 18 is supplied to the adding circuit 21 through a capacitor 22. An output signal of the adding circuit 21 is negatively fed back to the vertical drive circuit 15. The vertical linearity is corrected by this negative feedback circuit.

A resistor 23 and an FET 24 serving as a variable impedance element are connected in parallel with the detecting resistor 18. The control voltage $V_c$ obtained in the manner as mentioned above is added from a terminal 25 to a gate of the FET 24. Therefore, the impedance between the drain-source of the FET 24 is controlled by the control voltage $V_c$ and the amount of negative feedback to the vertical drive amplifier 15 is controlled and the vertical amplitude is corrected.

As well as the control of the vertical amplitude, the invention can be applied to other problems which are caused when the vertical frequency changes, for example, to the control of the vertical amplitude when correcting the change in amplitude of a vertical parabolic voltage for use in correction of right and left pin distortions.

## Claims

1. Apparatus for controlling the amplitude of a vertical deflection signal, the apparatus comprising:
   a vertical oscillating circuit (2) for generating a sawtooth signal having a vertical blanking period;
   a detecting circuit (5, 6, 7) for detecting whether the amplitude of said sawtooth signal is in a predetermined level range;
   a counter (9) for counting a vertical synchronizing signal, in response to an output of said detecting circuit (5, 6, 7), when the amplitude of said sawtooth signal is out of said range; and
   a digital-to-analogue converter (12) for converting an output of said counter (9) into an analogue detection signal, the output of said digital-to-analogue converter (12) being supplied to said vertical oscillating circuit (2);
   the amplitude of a vertical deflection signal formed by said sawtooth signal being controlled by an output of said digital-to-analogue converter (12).

2. Apparatus according to claim 1 wherein said detecting circuit (5, 6, 7) includes an amplitude detecting circuit (5, 6) for detecting the amplitude of said sawtooth signal and a level discriminating circuit (7) for discriminating whether the amplitude of said sawtooth signal is in said range, said level discriminating circuit (7) being supplied with the output of said amplitude detecting circuit (5, 6), and wherein said counter (9) is controlled to count up or count down by the output signal of said amplitude detecting circuit (5, 6) and to count said vertical synchronizing signal by an output signal of said level discriminating circuit (7).

3. Apparatus according to claim 2 wherein said amplitude detecting circuit (5, 6) comprises a first amplitude detecting circuit (5) having a first threshold level and a second amplitude detecting circuit (6) having a second threshold level.

4. Apparatus according to claim 3 wherein said level discriminating circuit (7) is supplied with a vertical blanking signal and discriminates during vertical blanking intervals.

5. Apparatus according to claim 4 wherein said vertical synchronizing signal is gated to said counter (9) by the output of said level discriminating circuit (7).

6. Apparatus according to claim 1 further comprising:
   a vertical drive circuit (3) supplied with an output of said vertical oscillating circuit (2);
   a vertical deflection coil (4) supplied with the vertical deflection signal from said vertical drive circuit (3);
   a series circuit (17, 18) comprising a capacitor (17) and a resistor (18) connected to said vertical deflection coil (4); and
   a variable impedance device (24) having a control terminal and connected in parallel with said resistor (18);
   wherein said analogue detection output is supplied to said control terminal of said variable impedance device (24).

## Revendications

1. Dispositif pour commander l'amplitude d'un signal de déviation verticale, le dispositif comprenant:
   un circuit d'oscillation verticale (2) pour générer un signal en dents de scie qui a une période de blanc verticale ;
   un circuit de détection (5, 6, 7) pour détecter si oui ou non l'amplitude dudit signal en dents de scie s'inscrit dans une plage de niveau prédéterminée ;
   un compteur (9) pour compter un signal de synchronisation verticale en réponse à une sortie dudit circuit de détection (5, 6, 7) lorsque l'amplitude dudit signal en dents de scie se situe en dehors de ladite plage ; et
   un convertisseur numérique/analogique (12) pour convertir une sortie dudit compteur (9) en un signal de détection analogique, la sortie dudit convertisseur numérique/analogique (12) étant acheminée audit circuit d'oscillation verticale (2) ;

l'amplitude d'un signal de déviation verticale qui est formé par ledit signal en dents de scie étant commandée par une sortie dudit convertisseur numérique/analogique (12).

2. Dispositif selon la revendication 1, dans lequel ledit circuit de détection (5, 6, 7) comprend un circuit de détection d'amplitude (5, 6) pour détecter l'amplitude dudit signal en dents de scie et un circuit de discrimination de niveau (7) pour discriminer si oui ou non l'amplitude dudit signal en dents de scie s'inscrit dans ladite plage, ledit circuit de discrimination de niveau (7) étant alimenté par la sortie dudit circuit de détection d'amplitude (5, 6), et dans lequel ledit compteur (9) est commandé, pour effectuer un comptage positif ou pour effectuer un comptage négatif, par le signal de sortie dudit circuit de détection d'amplitude (5, 6) et pour compter ledit signal de synchronisation verticale, par un signal de sortie dudit circuit de discrimination de niveau (7).

3. Dispositif selon la revendication 2, dans lequel ledit circuit de détection d'amplitude (5, 6) comprend un premier circuit de détection d'amplitude (5) qui a un premier niveau de seuil et un second circuit de détection d'amplitude (6) qui a un second niveau de seuil.

4. Dispositif selon la revendication 3, dans lequel ledit circuit de discrimination de niveau (7) est alimenté avec un signal de blanc vertical et effectue sa discrimination pendant des intervalles de blanc vertical.

5. Dispositif selon la revendication 4, dans lequel ledit signal de synchronisation verticale est acheminé au moyen d'une porte jusqu'audit compteur (9) par la sortie dudit circuit de discrimination de niveau (7).

6. Dispositif selon la revendication 1, comprenant en outre :

un circuit de commande verticale (3) qui est alimenté avec une sortie dudit circuit d'oscillation verticale (2) ;

une bobine de déviation verticale (4) qui est alimentée avec le signal de déviation verticale qui provient dudit circuit de commande verticale (3) ;

un circuit série (17, 18) qui comprend une capacité (17) et une résistance (18) qui sont connectées à ladite bobine de déviation verticale (4) ; et

un dispositif à impédance variable (24) qui a une borne de commande et qui est connecté en parallèle avec ladite résistance (18) ; et

dans lequel ladite sortie de détection analogique est acheminée jusqu'à ladite borne de commande dudit dispositif à impédance variable (24).

**Patentansprüche**

1. Vorrichtung zur Steuerung der Amplitude eines vertikalen Ablenksignals, bestehend aus

einer vertikalen Oszillatorschaltung (2) zur Erzeugung eines Sägezahnsignals mit einer vertikalen Austastperiode,

einer Detektorschaltung (5, 6, 7) zur Feststellung, ob die Amplitude des Sägezahnsignals innerhalb eines vorbestimmten Pegelbereichs liegt,

einem Zähler (9) zum Abzählen eines vertikalen Synchronisiersignals in Abhängigkeit von dem Ausgangssignal der Detektorschaltung (5, 6, 7), wenn die Amplitude des Sägezahnsignals außerhalb des genannten Bereichs liegt, und

einem Digital/Analog-Wandler (12) zur Umwandlung des Ausgangssignals des Zählers (9) in ein analoges Detektorsignal, wobei das Ausgangssignal des Digital/Analog-Wandlers (12) der vertikalen Oszillatorschaltung (2) zugeführt wird, und

wobei die Amplitude eines von dem Sägezahnsignal gebildeten vertikalen Ablenksignals durch das Ausgangssignal des Digital/Analog-Wandlers (12) gesteuert wird.

2. Vorrichtung nach Anspruch 1, bei der die Detektorschaltung (5, 6, 7) eine Amplitudendetektorschaltung (5, 6) zur Detektierung der Amplitude des Sägezahnsignals aufweist sowie eine Pegeldiskriminatorschaltung (7), die feststellt, ob die Amplitude des Sägezahnsignals innerhalb des genannten Bereichs liegt, wobei dieser Pegeldiskriminatorschaltung (7) das Ausgangssignal der Amplitudendetektorschaltung (5, 6) zugeführt wird, und wobei der Zähler (9) durch das Ausgangssignal der Amplitudendetektorschaltung (5, 6) zum Zählen in Aufwärts- oder Abwärtsrichtung veranlaßt wird, während er durch das Ausgangssignal der Pegeldiskriminatorschaltung (7) zum Zählen des vertikalen Synchronisiersignal veranlaßt wird.

3. Vorrichtung nach Anspruch 2, bei der die Amplitudendetektorschaltung (5, 6) eine erste Amplitudendetektorschaltung (5) mit einem ersten Schwellwertpegel und eine zweite Amplitudendetektorschaltung (6) mit einem zweiten Schwellwertpegel umfaßt.

4. Vorrichtung nach Anspruch 3, bei der die Pegeldiskriminatorschaltung (7) mit einem vertikalen Austastsignal beaufschlagt wird und während der vertikalen Austastperioden ihre Diskriminatorfunktion ausübt.

5. Vorrichtung nach Anspruch 4, bei der die Zuführung des vertikalen Synchronisiersignals zu dem Zähler (9) durch das Ausgangssignal der Pegeldiskriminatorschaltung (7) gegattert wird.

6. Vorrichtung nach Anspruch 1, die ferner enthält:

eine vertikale Treiberschaltung (3), der das Ausgangssignal der vertikalen Oszillatorschaltung (2) zugeführt wird,

eine vertikale Ablenkspule (4), der das vertikale Ablenksignal aus der vertikalen Treiberschaltung (3) zugeführt wird,

eine mit der vertikalen Ablenkspule (4) verbundene Reihenschaltung (17, 18) aus einem Kondensator (17) und einem Widerstand (18) und

eine parallel zu dem Widerstand (18) angeordnete Vorrichtung (24) mit variabler Impedanz mit einem Steuereingang,

wobei das analoge Detektorausgangssignal dem Steuereingang der Vorrichtung (24) mit variabler Impedanz zugeführt wird.

# Fig. 1

# Fig.2A

FV₁

# Fig.2B

FV₂

# Fig.2C

FV₃

# Fig. 3A

# Fig. 3B

# Fig. 4

# Fig.5A

# Fig.5B